(19)

Europäisches
Patentamt
European
Patent Office
Office européen
des brevets

(11)  **EP 1 819 047 B1**

(12)  **EUROPEAN PATENT SPECIFICATION**

(45) Date of publication and mention
of the grant of the patent:
**25.07.2012  Bulletin 2012/30**

(51) Int Cl.:
*H03K 19/003* (2006.01)   *H03K 19/00* (2006.01)
*G06F 1/10* (2006.01)

(21) Application number: **06002881.8**

(22) Date of filing: **13.02.2006**

(54) **Circuit and method for reducing jitter and /or phase jump problems in a clock amplifier device**

Schaltung und Verfahren zur Reduzierung von Jitter- und/oder Phasensprung-Problemen in einem Taktsignalverstärkergerät

Circuit et methôde de reduction des problèmes jitter et/ou sauts de phase dans un dispositif amplificateur de signaux d'horloge

(84) Designated Contracting States:
**DE FR GB**

(43) Date of publication of application:
**15.08.2007  Bulletin 2007/33**

(73) Proprietor: **Infineon Technologies AG**
**85579 Neubiberg (DE)**

(72) Inventor: **Hjelm, Mikael**
**72231 Västeras (SE)**

(74) Representative: **Schoppe, Fritz et al**
**Schoppe, Zimmermann, Stöckeler & Zinkler**
**Patentanwälte**
**Postfach 246**
**82043 Pullach bei München (DE)**

(56) References cited:
**EP-A- 0 601 466**      **US-A- 6 144 223**
**US-A1- 2002 190 798**  **US-A1- 2005 077 929**
**US-B1- 6 335 633**     **US-B1- 6 426 661**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

**TECHNICAL FIELD OF THE INVENTION**

The present invention generally relates to clock amplifiers, and more specifically the invention refers to a circuit and a method, respectively, for reducing jitter and/or phase jump problems in a clock amplifier device due to variations in the voltage supplied to the clock amplifier device.

**BACKGROUND OF THE INVENTION**

The standard clock amplifier used in CMOS circuits is an inverter chain. The first stage in the inverter chain sets a lot of the jitter performance, especially if the clock signal has slow flanks, i.e. is sinusoidal. A problem is that the first inverter switching point is dependent on the supply voltage so any ripple on the supply voltage will lead to a modulation of the amplified clock signal. In a simple example the switching point is moving about half the supply voltage variation. This not only causes jitter, but also phase jumps, which can be disastrous for ongoing transmissions/receptions.

Solutions currently used comprise to decouple the clock amplifier with capacitors and/or to use separate supplies. The disadvantage with capacitors is that they have to be large if the voltage that varies over long periods of time is to be inhibited, thereby occupying valuable chip area. Separate supplies increase complexity and are costly.

US 2002/190798 A1 discloses a ring oscillator circuit which is made by connecting K units of inverter circuits in a ring shape. Each inverter circuit comprises a CMOS inverter which includes MOS transistors, a P-channel MOS transistor which functions as the current source for a CMOS inverter, an N-channel MOS transistor which functions as the current source for a first CMOS inverter, and a second CMOS inverter which is connected in parallel to the CMOS inverter and includes MOS transistors.

EP 0 601 466 A2 discloses a signal input circuit having a CMOS inverter for receiving an input signal of a TTL level. The circuit includes a first transistor of one channel type connected between a first power terminal and an output terminal and having a gate connected to an input terminal, a second transistor of an opposite channel type connected between a second power terminal and the output terminal and having a gate connected to the input terminal, and a current gain control circuit coupled to the first transistor for controlling the current gain of the first transistor to a first value when a power voltage is at a first level and to a second value when the power voltage is at a second level.

US 6,426 661 B1 discloses a voltage-compensated, constant delay clock buffer for a chip clock distribution circuit employs a variable gain circuit to dynamically control the delay through the first inverter stage. In the presence of no voltage rail collapse the first stage gain is set high which results in a nominal delay through the first stage. As voltage rail collapse occurs local to the clock buffer circuit, the gain on the first stage is reduced to yield a smaller than nominal delay through the first stage in such a way as to compensate for the increased delay in the subsequent stage or stages. The control circuit is responsive to a first voltage rail and a second voltage rail to provide dynamic control of the delay through the first inverter stage. The circuit can compensate the circuit to handle a plurality of second inverter stages with the control circuit adjusting the delay of said first inverter stage, and with the control circuit remaining responsive to a first voltage rail and a second voltage rail.

**SUMMARY OF THE INVENTION**

It is an object of the present invention to provide a circuit and a method, respectively, for reducing jitter and/or phase jump problems in a clock amplifier device due to variations in the voltage supplied to the clock amplifier device, which alleviate the above shortcomings and drawbacks of the current solutions.

It is in this respect a particular object of the invention to provide such a circuit, which does not require large and bulky capacitors or separate voltage supplies for the clock amplifier.

These objects are according to the present invention attained by circuits and methods as claimed in the appended patent claims.

According to an aspect of the invention there is provided a circuit comprising an input terminal connected to the supply voltage to allow the circuit to sense the actual supply voltage, and an output terminal connected to an output of the clock amplifier. The circuit is provided to draw a current from, or feed a current to, the output of the clock amplifier device via the output terminal in response to a difference between the sensed actual supply voltage and a desired supply voltage.

The current is proportional to the above voltage difference and is determined so that the switching point of the clock amplifier device is adjusted to the position it would have had provided that the sensed actual supply voltage would have been identical with the desired voltage.

The circuit is preferably implemented in a first stage of a CMOS inverter chain in a GPS navigator device, although it may be used in other amplifiers and devices, such as in radio frequency receivers and transmitters and AD and DA circuits, as well as for other applications.

According to a further aspect of the invention there is provided a method comprising the steps of sensing the actual voltage supplied to a clock amplifier, calculating a difference between the sensed actual voltage supplied to the clock amplifier and a desired supply voltage, and drawing a current from, or feeding a current to, an output of the clock amplifier in response to the calculated difference between the sensed voltage supplied to the clock amplifier device and the desired supply voltage.

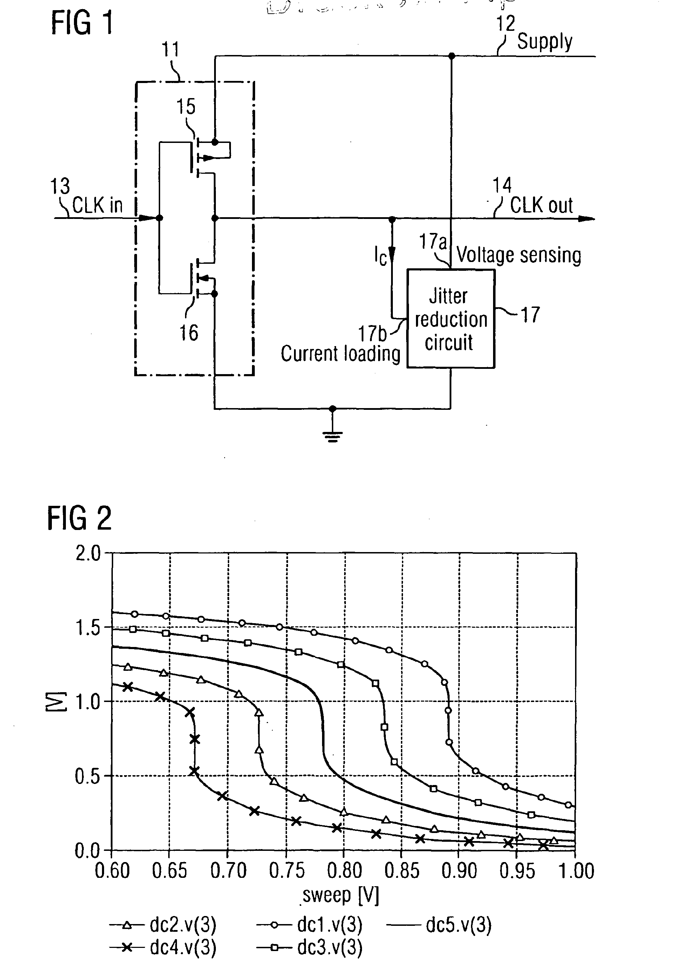

Further characteristics of the invention and advantages thereof will be evident from the detailed description of preferred embodiments of the present invention given hereinafter and the accompanying Figs. 1-5, which are only given by way of illustration, and thus are not limitative of the present invention.

## BRIEF DESCRIPTION OF THE DRAWINGS

Fig. 1 illustrates a clock amplifier device including a circuit for reducing jitter and/or phase jump problems according to an embodiment of the present invention.

Figs. 2-3 are diagrams of output voltage versus input voltage for a prior art clock amplifier device, and for the clock amplifier device of Fig. 1, respectively, for different supply voltages.

Figs. 4-5 illustrate example implementations of the circuit for reducing jitter and/or phase jump problems of Fig. 1.

## DETAILED DESCRIPTION OF EMBODIMENTS

An embodiment of a clock amplifier device including a circuit for mitigating jitter and/or phase jump problems in accordance with the present invention is shown in Fig. 1. preferably, the clock amplifier device is a monolithically integrated single-chip device.

The clock amplifier device comprises a clock amplifier circuit 11 connected to, and supplied by, a supply voltage 12. The clock amplifier circuit 11 has an input for receiving a clock input signal 13 and an output for outputting a clock output signal 14, and comprises preferably a conventional CMOS-based inverter including a PMOS transistor 15 and an NMOS transistor 16. Preferably, the CMOS-based inverter is a first of a number of inverters or inverter stages together forming an inverter chain. Inverters and inverter chains of this kind are e.g. disclosed in U.S. Patent Nos. 4,734,597 and 5,767,728, and in U.S. Patent Pub. Nos. 2002/0075090 and 2001/0054926, the contents of which being hereby incorporated by reference.

Due to noise and other variations, e.g. caused by load pulling, in the voltage 12 supplied to the clock amplifier circuit 11 jitter and/or phase jumps may be obtained in the clock output signal 14. Therefore, in accordance with the present invention, a circuit 17 for reducing this jitter and phase jumps is provided. The circuit comprises an input terminal 17a connected to the supply voltage 12 to allow the circuit 17 to sense the actual instantaneous voltage supplied to the clock amplifier device, i.e. all variations that occur. An output terminal 17b of the circuit 17 is connected to the output of the clock amplifier circuit 11, wherein the circuit is configured to draw a current $I_c$ from, or feed a current to, the clock amplifier circuit 11 via its output terminal 17b in response to a difference between the sensed actual voltage supplied to the clock amplifier circuit 11 and a desired supply voltage.

The current $I_c$ is proportional to the voltage difference according to

$$I_c = c * (V_S - V_D) \qquad (Eq. 1)$$

where $V_S$ is the sensed actual voltage supplied to the clock amplifier circuit 11, $V_D$ is the desired supply voltage (i.e. the ideal supply voltage in case no noise or variations occur in the supply voltage, and c is a constant dependent on the clock amplifier circuit 11.

The circuit 17 is effective to move or adjust the switching point of the clock amplifier circuit 11 towards the switching point obtained when the clock amplifier circuit 17 is supplied with the desired or ideal supply voltage. If the sensed actual supply voltage is higher than the desired supply voltage, i.e. $V_S > V_D$, a current is drawn from the clock amplifier circuit 11, and if the sensed actual supply voltage is lower than the desired supply voltage, i.e. $V_S < V_D$, a current is fed to the clock amplifier circuit 11.

Figs. 2-3 are diagrams of output voltage versus input voltage for a clock amplifier without the circuit 17, and for the clock amplifier device of Fig. 1, i.e. with the circuit 17, respectively, for different supply voltages. The solid line corresponds to a supply voltage of 1.5 V, which is chosen as the desired or ideal supply voltage, the x-marked curve corresponds to a supply voltage of 1.3 V, the curve with triangles corresponds to a supply voltage of 1.4 V, the curve with squares corresponds to a supply voltage of 1.6 V, and the curve with circles corresponds to a supply voltage of 1.7 V.

In Fig. 2 it can be seen that the switching point is quite different for the different supply voltages. For the desired or ideal supply voltage of 1.5 V, the switching point is at an input voltage of about 0.78 V, whereas for the most extreme supply voltages, 1.3 V and 1.7 V, the switching points are at input voltages of about 0.67 V and 0.89 V.

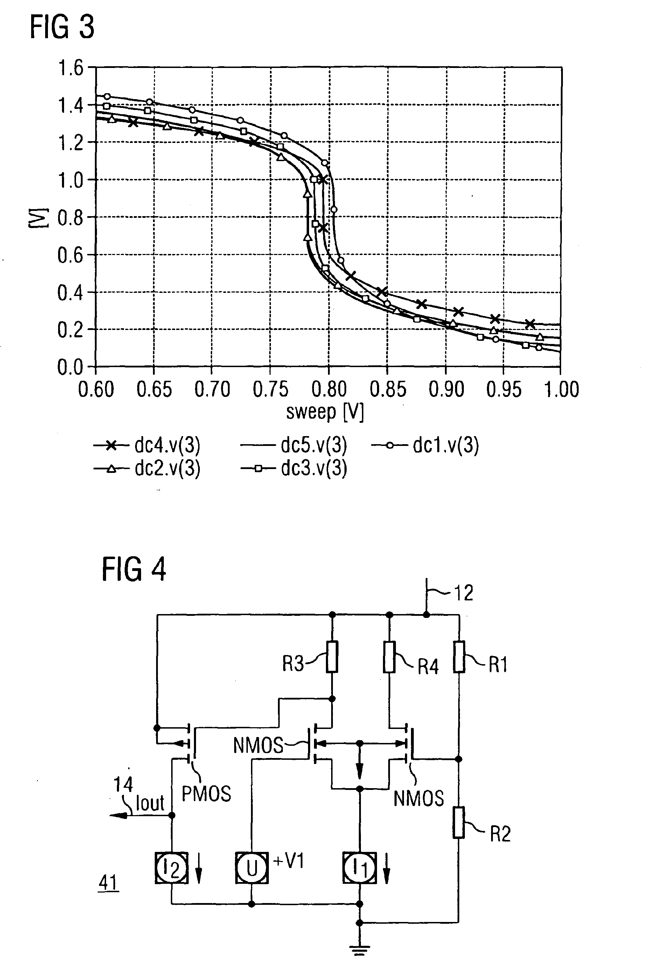

In Fig. 3 it can be seen that the switching points are very similar (i.e. varies from 0.78 V to 0.81 V) almost independent of the supply voltage. The value of the constant c may be calculated analytically or may be retrieved by means of simulations.

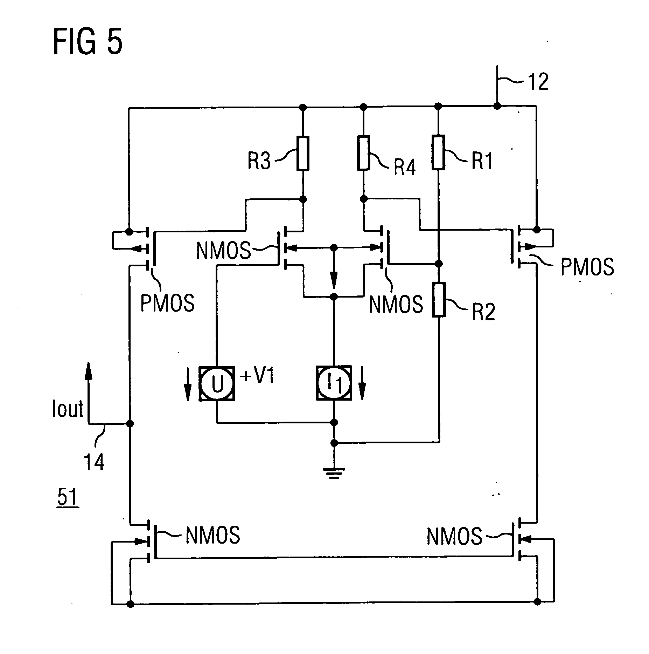

The circuit 17, having a transfer function according to Eq. 1, may be designed in a plurality of manners readily known to a person skilled in the art. Nevertheless, two exemplary implementations are shown in Figs. 4 and 5. The connections to the supply voltage 12 and to the clock output 14 are indicated. R1, R2, R3, and R4 denote resistors, NMOS and PMOS denote transistors of NMOS and PMOS type, respectively, U denotes a voltage source, and $I_1$ and $I_2$ denote current sources. The selection of appropriate electrical parameters of the components above is readily made or retrieved by a person skilled in the art.

The invention is preferably implemented in a clock amplifier of a GPS navigator device since the jitter and phase jumps seem to be particularly troublesome there. However, the invention is not limited to such implementation, but may be implemented in any kind of device or application using a clock amplifier circuit having similar problems with jitter and phase jumps.

In the preceding detailed description, the invention is described with reference to specific exemplary embodiments thereof. Various modifications and changes may be made thereto without departing from the scope of the invention as set forth in the claims. The specification and drawings are, accordingly, to be regarded in an illustrative rather than a restrictive sense.

**Claims**

1.  A circuit (17) for reducing jitter and/or phase jump problems in a clock amplifier device (11) due to variations in the voltage (12) supplied to the clock amplifier device, wherein said circuit comprises:

    - an input terminal (17a) connected to said voltage supplied to the clock amplifier device so as to allow said circuit to sense the actual voltage supplied to the clock amplifier device, and
    - an output terminal (17b),
    **characterized in that**
    - said output terminal (17b) is connected to an output (14) of said clock amplifier device, and
    said circuit is adapted to draw a current from, or feed a current to, the output of said clock amplifier device, which is proportional to the difference between the sensed actual voltage supplied to the clock amplifier device and a desired supply voltage so as to thereby move a switching point of said clock amplifier device towards the switching point obtained if said clock amplifier device would have been supplied with the desired supply voltage.

2.  The circuit of claim 1, wherein said clock amplifier device is an inverter chain and said circuit is implemented in a first stage of said chain.

3.  The circuit of claim 1 or 2, wherein said circuit is implemented in a GPS navigator device.

4.  The circuit of claim 1 or 2, wherein said circuit is implemented in a radio frequency receiver or transmitter.

5.  The circuit of claim 1 or 2, wherein said circuit is implemented in an AD or DA circuit, preferably a high precision AD or DA circuit.

6.  A method for reducing jitter and/or phase jump problems in a clock amplifier device (11) due to variations in the voltage (12) supplied to the clock amplifier device, wherein said method comprises the steps of:

    - sensing the actual voltage supplied to the clock amplifier device, and
    - calculating a difference between the sensed actual voltage supplied to the clock amplifier device and a desired supply voltage,
    **characterized by**
    - drawing a current from, or feeding a current to, an output (14) of said clock amplifier device (11) in response to said calculated difference between the sensed voltage supplied to the clock amplifier device and the desired supply voltage,

wherein said current drawn from, or fed to, the output of said clock amplifier device, is proportional to the difference between the sensed actual voltage supplied to the clock amplifier device and a desired supply voltage so as to thereby move a switching point of said clock amplifier device towards the switching point obtained if said clock amplifier device would have been supplied with the desired supply voltage.

7. The method of claim 6, wherein said method is performed in a first stage of an inverter chain.

8. The method of claim 6 or 7, wherein said method is performed in a GPS navigator device.

**Patentansprüche**

1. Eine Schaltung (17) zum Reduzieren von Jitter- und/oder Phasensprung-Problemen in einem Taktverstärkerbauelement (11) aufgrund von Abweichungen bei der Spannung (12), die zu dem Taktverstärkerbauelement geliefert wird, wobei die Schaltung folgende Merkmale aufweist:

einen Eingangsanschluss (17a), der mit der Spannung verbunden ist, die zu dem Taktverstärkerbauelement geliefert wird, um zu ermöglichen, dass die Schaltung die tatsächliche Spannung erfasst, die zu dem Taktverstärkerbauelement geliefert wird, und
einen Ausgangsanschluss (17b),
**dadurch gekennzeichnet, dass**
der Ausgangsanschluss (17b) mit einem Ausgang (14) des Taktverstärkerbauelements verbunden ist, und die Schaltung angepasst ist, um Strom von dem Ausgang des Taktverstärkerbauelements zu ziehen oder zu demselben zu liefern, der proportional zu der Differenz zwischen der erfassten tatsächlichen Spannung, die zu dem Taktverstärkerbauelement geliefert wird, und einer gewünschten Versorgungsspannung ist, um **dadurch** einen Schaltpunkt des Taktverstärkerbauelements hin zu dem Schaltpunkt zu bewegen, der erhalten wird, wenn das Taktverstärkerbauelement mit der gewünschten Versorgungsspannung beliefert worden wäre.

2. Die Schaltung gemäß Anspruch 1, bei der das Taktverstärkerbauelement eine Inverterkette ist und die Schaltung in einer ersten Stufe der Kette implementiert ist.

3. Die Schaltung gemäß Anspruch 1 oder 2, wobei die Schaltung in einem GPS-Navigatorbauelement implementiert ist.

4. Die Schaltung gemäß Anspruch 1 oder 2, wobei die Schaltung als ein Hochfrequenz-Empfänger oder -Sender implementiert ist.

5. Die Schaltung gemäß Anspruch 1 oder 2, wobei die Schaltung in einer AD- oder DA-Schaltung implementiert ist, vorzugsweise einer Hochpräzisions-AD- oder -DA-Schaltung.

6. Ein Verfahren zum Reduzieren von Jitter- und/oder Phasensprung-Problemen bei einem Taktverstärkerbauelement (11) aufgrund von Abweichungen bei der Spannung (12), die zu dem Taktverstärkerbauelement geliefert wird, wobei das Verfahren folgende Schritte aufweist:

Erfassen der tatsächlichen Spannung, die zu dem Taktverstärkerbauelement geliefert wird, und
Berechnen einer Differenz zwischen der erfassten, tatsächlichen Spannung, die zu dem Taktverstärkerbauelement geliefert wird, und einer gewünschten Versorgungsspannung,
**gekennzeichnet durch**
Abziehen eines Stroms von oder Zuführen eines Stroms zu einem Ausgang (14) des Taktverstärkerbauelements (11) ansprechend auf die berechnete Differenz zwischen der erfassten Spannung, die zu dem Taktverstärkerbauelement geliefert wird, und der gewünschten Versorgungsspannung,
wobei der Strom, der gezogen wird von oder zugeführt wird zu dem Ausgang des Taktverstärkerbauelements proportional ist zu der Differenz zwischen der erfassten, tatsächlichen Spannung, die zu dem Taktverstärkerbauelement geliefert wird und einer gewünschten Versorgungsspannung, um **dadurch** einen Schaltpunkt des Taktverstärkerbauelements hin zu dem Schaltpunkt zu bewegen, der erhalten wird, wenn das Taktverstärkerbauelement mit der gewünschten Versorgungsspannung beliefert worden wäre.

**7.** Das Verfahren gemäß Anspruch 6, wobei das Verfahren in einer ersten Stufe einer Inverterkette ausgeführt wird.

**8.** Das Verfahren gemäß Anspruch 6 oder 7, wobei das Verfahren in einem GPS-Navigatorbauelement ausgeführt wird.

## Revendications

**1.** Circuit (17) pour réduire les problèmes de gigue et/ou de saut de phase dans un dispositif amplificateur d'horloge (11) dus à des variations dans la tension (12) alimentée vers le dispositif amplificateur d'horloge, dans lequel ledit circuit comprend:

- une borne d'entrée (17a) connectée à ladite tension alimentée vers le dispositif amplificateur d'horloge de manière que ledit circuit détecte la tension réelle alimentée vers le dispositif amplificateur d'horloge, et
- une borne de sortie (17b),
**caractérisé par le fait que**
- ladite borne de sortie (17b) est connectée à une sortie (14) dudit dispositif amplificateur d'horloge, et
- ledit circuit est adapté pour prélever un courant de, ou alimenter un courant vers, la sortie dudit dispositif amplificateur d'horloge qui est proportionnel à la différence entre la tension réelle détectée alimentée vers le dispositif amplificateur d'horloge et une tension d'alimentation désirée de manière à déplacer ainsi un point de commutation dudit dispositif amplificateur d'horloge vers le point de commutation obtenu si ledit dispositif amplificateur d'horloge était alimenté par la tension d'alimentation désirée.

**2.** Circuit selon la revendication 1, dans lequel ledit dispositif amplificateur d'horloge est une chaîne d'inverseurs et ledit circuit est mis en oeuvre dans un premier étage de ladite chaîne.

**3.** Circuit selon la revendication 1 ou 2, dans lequel ledit circuit est mis en oeuvre dans un dispositif de navigation GPS.

**4.** Circuit selon la revendication 1 ou 2, dans lequel ledit circuit est mis en oeuvre dans un récepteur ou émetteur à radiofréquence.

**5.** Circuit selon la revendication 1 ou 2, dans lequel ledit circuit est mis en oeuvre dans un circuit AN ou NA, de préférence un circuit AN ou NA de haute précision.

**6.** Procédé pour réduire les problèmes de gigue et/ou de saut de phase dans un dispositif amplificateur d'horloge (11) dus à des variations dans la tension (12) alimentée vers le dispositif amplificateur d'horloge dans lequel ledit procédé comprend les étapes consistant à:

- détecter la tension actuelle alimentée vers le dispositif amplificateur d'horloge, et
- calculer une différence entre la tension réelle détectée alimentée vers le dispositif amplificateur d'horloge et une tension d'alimentation désirée,

**caractérisé par** le fait de
prélever un courant de, ou alimenter un courant vers, une sortie (14) dudit dispositif amplificateur d'horloge (11) en réponse à ladite différence calculée entre la tension détectée alimentée vers le dispositif amplificateur d'horloge et la tension d'alimentation désirée,
dans lequel ledit courant prélevé de, ou alimenté vers, la sortie dudit dispositif amplificateur d'horloge est proportionnel à la différence entre la tension réelle détectée alimentée vers le dispositif amplificateur d'horloge et une tension d'alimentation désirée de manière à déplacer ainsi un point de commutation dudit dispositif amplificateur d'horloge vers le point de commutation obtenu si ledit dispositif amplificateur d'horloge avait été alimenté par la tension d'alimentation désirée.

**7.** Procédé selon la revendication 6, dans lequel ledit procédé est réalisé dans un premier étage d'une chaîne d'inverseurs.

**8.** Procédé selon la revendication 6 ou 7, dans lequel ledit procédé est réalisé dans un dispositif de navigation GPS.

**FIG 1**

**FIG 2**

$\triangle$ dc2.v(3)     $\circ$ dc1.v(3)     —— dc5.v(3)

$\times$ dc4.v(3)     $\square$ dc3.v(3)

## FIG 3

—✕— dc4.v(3)    ——— dc5.v(3)    —○— dc1.v(3)

—△— dc2.v(3)    —□— dc3.v(3)

## FIG 4

FIG 5

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2002190798 A1
- EP 0601466 A2
- US 6426661 B1
- US 4734597 A
- US 5767728 A
- US 20020075090 A
- US 20010054926 A